# EUROPEAN PATENT APPLICATION

(11) **EP 4 386 876 A1**
(43) Date of publication of application: **19.06.2024**
(21) Application number: 22863890.4
(22) Date of filing: 17.03.2022
(51) Int. Cl.: H01L 33/14, G09F 9/33, H01L 33/02

(54) **LIGHT EMITTING DEVICE AND IMAGE DISPLAY DEVICE**

(30) Priority: 30.08.2021 JP 2021140413
(71) Applicant: Sony Group Corporation, Tokyo 108-0075 (JP)
(72) Inventor: HIRAO, Naoki, Tokyo 108-0075 (JP); OYAMA, Yusuke, Tokyo 108-0075 (JP)
(74) Representative: D Young & Co LLP
(86) International application number: PCT/JP2022/012126
(87) International publication number: WO 2023/032300

(57) **Abstract**

A light emitting device according to one embodiment of the present disclosure includes a first compound semiconductor layer having a first surface and a second surface that are opposed to each other, an active layer facing the second surface of the first compound semiconductor layer, a second compound semiconductor layer having a third surface that faces the active layer and a fourth surface that is opposed to the third surface and serves as a light exit surface and including one or a plurality of light collecting structures on the fourth surface, and a current narrowing structure provided within the first compound semiconductor layer or the second compound semiconductor layer.

## Description

### Technical Field

The present disclosure relates to a light emitting device, and to an image display apparatus including the same.

### Background Art

For example, PTL 1 discloses a light emitting element that includes a concave mirror section in a first light reflection layer provided on an opposite side of a light extraction side.

### Citation List

### Patent Literature

PTL 1: International Publication No. WO2019/124163

### Summary of the Invention

Meanwhile, in a micro-sized display, it is necessary to improve light extraction efficiency.

It is desirable to provide a light emitting device and an image display apparatus that are able to improve light extraction efficiency.

Alight emitting device according to one embodiment of the present disclosure includes a first compound semiconductor layer having a first surface and a second surface opposed to each other, an active layer facing the second surface of the first compound semiconductor layer, a second compound semiconductor layer having a third surface that faces the active layer and a fourth surface that is opposed to the third surface and serves as a light exit surface, and including one or a plurality of light collecting structures on the fourth surface, and a current narrowing structure provided in the first compound semiconductor layer or the second compound semiconductor layer.

An image display apparatus according to one embodiment of the present disclosure includes a plurality of light emitting devices for each of a plurality of pixels arranged in an array, and includes the light emitting device according to the above one embodiment of the present disclosure as the plurality of light emitting devices.

In the light emitting device according to one embodiment of the present disclosure and the image display apparatus according to one embodiment of the present disclosure, the light collecting structure is provided on the light exit surface of the second compound semiconductor layer that is laminated in an order of the first compound semiconductor layer, the active layer, and the second compound semiconductor layer, and the current narrowing structure is also provided in the first compound semiconductor layer or the second compound semiconductor layer. This limits a light emitting region of the active layer and, for example, increases a proportion of light entering an acceptance angle of a lens that is provided above a plurality of light emitting devices and captures light emitted from the plurality of light emitting devices.

### Brief Description of Drawings

[FIG. 1] FIG. 1 is a cross-sectional schematic diagram illustrating an example of a configuration of a light emitting device according to one embodiment of the present disclosure.
[FIG. 2] FIG. 2 is a cross-sectional schematic diagram illustrating another example of the configuration of the light emitting device according to one embodiment of the present disclosure.
[FIG. 3] FIG. 3 is a cross-sectional schematic diagram illustrating another example of the configuration of a light emitting device according to one embodiment of the present disclosure.
[FIG. 4A] FIG. 4A is a cross-sectional schematic diagram describing a method of manufacturing the light emitting device illustrated in FIG. 2.
[FIG. 4B] FIG. 4B is a cross-sectional schematic diagram illustrating a process following FIG. 4A.
[FIG. 4C] FIG. 4C is a cross-sectional schematic diagram illustrating a process following FIG. 4B.
[FIG. 4D] FIG. 4D is a cross-sectional schematic diagram illustrating a process following FIG. 4C.
[FIG. 4E] FIG. 4E is a cross-sectional schematic diagram illustrating a process following FIG. 4D.
[FIG. 5] FIG. 5 is a cross-sectional schematic diagram illustrating an example of a configuration of a light emitting unit that includes a plurality of light emitting devices as illustrated in FIG. 2.
[FIG. 6A] FIG. 6A describes a difference in light collection effect depending on a light emission position in a general light emitting device.
[FIG. 6B] FIG. 6B describes a difference in light collection effect depending on a light emission position in a general light emitting device.
[FIG. 6C] FIG. 6C describes a difference in light collection effect depending on a light emission position in a general light emitting device.
[FIG. 7] FIG. 7 is a cross-sectional schematic diagram illustrating one example of a configuration of a light emitting device according to Modification Example 1 of the present disclosure.
[FIG. 8] FIG. 8 is a cross-sectional schematic diagram illustrating another example of the configuration of the light emitting device according to Modification Example 1 of the present disclosure.
[FIG. 9] FIG. 9 is a cross-sectional schematic diagram illustrating an example of a configuration of a light emitting device according to Modification Example 2 of the present disclosure.
[FIG. 10] FIG. 10 is a cross-sectional schematic diagram illustrating another example of the configuration of the light emitting device according to Modification Example 2 of the present disclosure.
[FIG. 11] FIG. 11 is a cross-sectional schematic diagram illustrating an example of a configuration of a light emitting device according to Modification Example 3 of the present disclosure.
[FIG. 12] FIG. 12 is a cross-sectional schematic diagram illustrating another example of the configuration of the light emitting device according to Modification Example 3 of the present disclosure.
[FIG. 13] FIG. 13 is a cross-sectional schematic diagram illustrating an example of a configuration of a light emitting device according to Modification Example 4 of the present disclosure.
[FIG. 14] FIG. 14 is a cross-sectional schematic diagram illustrating another example of the configuration of the light emitting device according to Modification Example 4 of the present disclosure.
[FIG. 15] FIG. 15 is a cross-sectional schematic diagram illustrating another example of the configuration of the light emitting device according to Modification Example 4 of the present disclosure.
[FIG. 16] FIG. 16 is a cross-sectional schematic diagram illustrating an example of a configuration of a light emitting device according to Modification Example 5 of the present disclosure.
[FIG. 17] FIG. 17 is a cross-sectional schematic diagram illustrating another example of the configuration of the light emitting device according to Modification Example 5 of the present disclosure.
[FIG. 18] FIG. 18 is a cross-sectional schematic diagram illustrating another example of the configuration of the light emitting device according to Modification Example 5 of the present disclosure.
[FIG. 19] FIG. 19 is a cross-sectional schematic diagram illustrating an example of a configuration of a light emitting device according to Modification Example 6 of the present disclosure.
[FIG. 20] FIG. 20 is a cross-sectional schematic diagram illustrating an example of a configuration of a light emitting unit that includes a plurality of light emitting devices as illustrated in FIG. 19.
[FIG. 21] FIG. 21 is a cross-sectional schematic diagram illustrating an example of a configuration of a light emitting device according to Modification Example 7 of the present disclosure.
[FIG. 22] FIG. 22 is a cross-sectional schematic diagram illustrating another example of the configuration of the light emitting device according to Modification Example 7 of the present disclosure.
[FIG. 23] FIG. 23 is a cross-sectional schematic diagram illustrating an example of a configuration of a light emitting unit according to Modification Example 8 of the present disclosure.
[FIG. 24] FIG. 24 is a cross-sectional schematic diagram illustrating another example of the configuration of the light emitting unit according to Modification Example 8 of the present disclosure.
[FIG. 25] FIG. 25 is a cross-sectional schematic diagram illustrating another example of the configuration of the light emitting unit according to Modification Example 8 of the present disclosure.
[FIG. 26] FIG. 26 is a perspective view illustrating an example of a configuration of an image display apparatus according to Application Example 1 of the present disclosure.
[FIG. 27] FIG. 27 is a schematic diagram illustrating an example of a layout of the image display apparatus illustrated in FIG. 26.
[FIG. 28] FIG. 28 is a perspective view illustrating an example of a configuration of an image display apparatus according to Application Example 2 of the present disclosure.
[FIG. 29] FIG. 29 is a perspective view illustrating a configuration of a mounting substrate illustrated in FIG. 28.
[FIG. 30] FIG. 30 is a perspective view illustrating a configuration of a unit substrate illustrated in FIG. 29.
[FIG. 31] FIG. 31 illustrates an example of an image display apparatus according to Application Example 3 of the present disclosure.

### Modes for Carrying Out the Invention

In the following, one embodiment of the present disclosure will be described in detail with reference to the drawings. The description below is a specific example of the present disclosure, and the present disclosure is not limited to the following embodiments. In addition, the arrangement, dimensions, dimension ratios, and the like of components in the present disclosure are not limited to those illustrated in each drawing. It is to be noted that the description will be given in the following order.
1. Embodiment (Example of a light emitting device in which a current narrowing region is provided in a first cladding layer and a light exit surface of a second cladding layer has a lens shape)
2. Modification Example 1 (Example of providing a plurality of lenses in the light exit surface of the second cladding layer)
3. Modification Example 2 (Example of providing a mesa in the first cladding layer)
4. Modification Example 3 (Example of providing a groove in the first cladding layer)
5. Modification Example 4 (Example of another structure of a second electrode)
6. Modification Example 5 (Example of providing a mirror structure in a lateral surface of the light emitting device)
7. Modification Example 6 (Another example of a lens shape)
8. Modification Example 7 (Example of providing a plurality of active layers)
9. Modification Example 8 (Another example of a configuration of a light emitting unit)
10. Application Example 1 (Example of an image display apparatus)
11. Application Example 2 (Example of an image display apparatus)
12. Application Example 3 (Example of an image display apparatus)

### <1. First Embodiment>

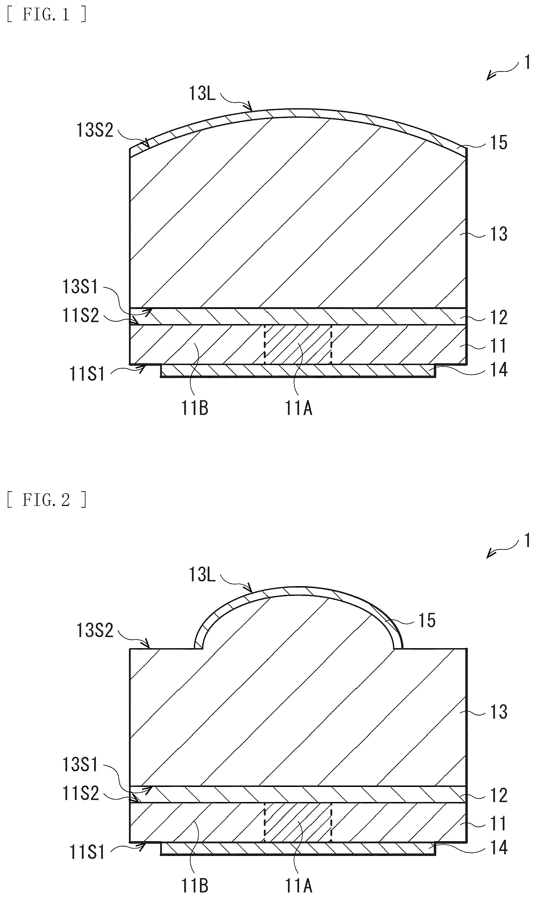

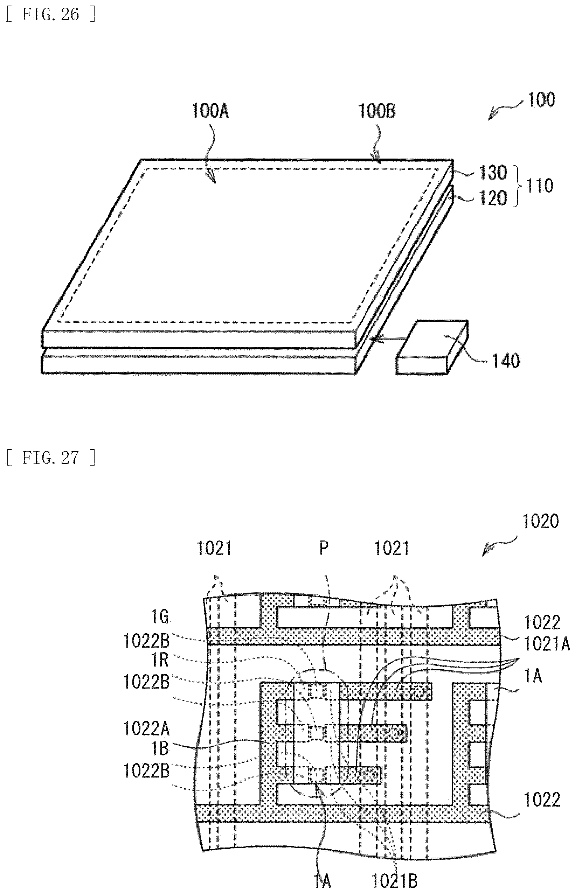

FIG. 1 schematically illustrates an example of a cross-sectional configuration of a light emitting device 1 according to one embodiment of the present disclosure. FIG. 2 schematically illustrates another example of the cross-sectional configuration of the light emitting device 1 according to one embodiment of the present disclosure. For example, the light emitting device 1 is preferably used in a display pixel P of an image display apparatus (for example, an image display apparatus 100, see FIG. 26).

### [Configuration of Light Emitting Device]

The light emitting device 1 includes a first cladding layer 11, an active layer 12, and a second cladding layer 13 that are laminated in this order. In the light emitting device 1, the second cladding layer 13 side is a light exit surface. The first cladding layer 11 has a pair of surfaces (surface 11S1 and surface 11S2) opposed to each other and includes a current narrowing structure therein. The active layer 12 is laminated on the surface 11S2 of the first cladding layer 11. The second cladding layer 13 has a pair of surfaces (surface 13S1 and surface 13S2) opposed to each other, with the surface 13S1 facing the active layer 12. The surface 13S2 is a light exit surface and includes a light collecting structure (lens 13L). On the surface 11S1 of the first cladding layer 11 and the surface 13S2 of the second cladding layer 13, a first electrode 14 and a second electrode 15 are provided, respectively.

The first cladding layer 11 corresponds to one specific example of a "first compound semiconductor layer" of the present disclosure and includes, for example, an n-type GaN-based compound semiconductor material. In the first cladding layer 11, a current narrowing structure is provided.

The current narrowing structure provides a narrowing effect to an electric current. The current narrowing structure includes a current injection region 11A and a current narrowing region 11B. In planar view, for example, the current injection region 11A is provided at substantially a center of the first cladding layer 11. The current narrowing region 11B is provided around the current injection region 11A. The current narrowing region 11B has an insulation property, and, for example, it is possible to form the current narrowing region 11B by ion implantation of an impurity from a surface (for example, the surface 11S1) of the first cladding layer 11 side. Other than this, it is also possible to form the current narrowing region 11B by oxidation from the first cladding layer 11 side. In addition, in a manufacturing process of the light emitting device 1 described later, when forming the first cladding layer 11 using epitaxial crystal growth, it is also possible to form the first cladding layer 11 by masking the current narrowing region 11B portion and growing a crystal in the current injection region 11A portion, and then growing a crystal in the current narrowing region 11B portion. Providing a current narrowing structure narrows an electric current injected from the first electrode 14 into the active layer 12, increasing current injection efficiency.

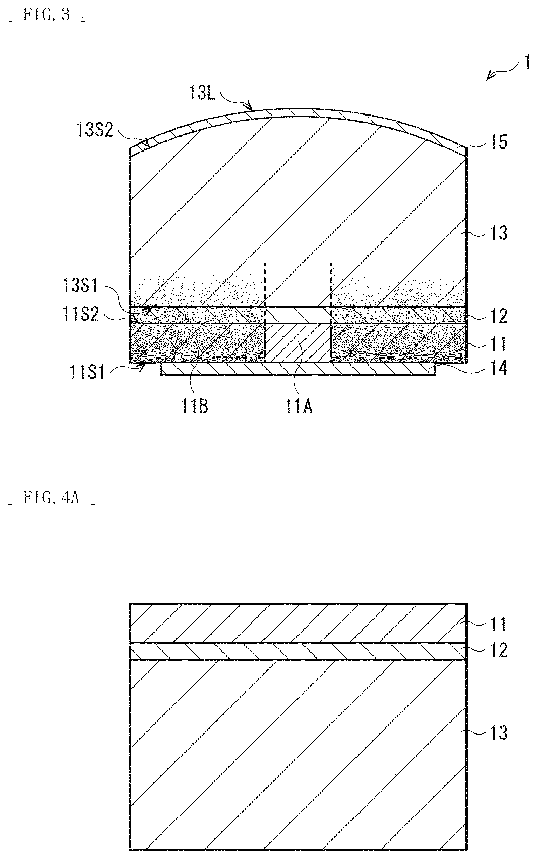

As illustrated in FIG. 3, for example, the current narrowing structure may be formed from the first cladding layer 11 to the second cladding layer 13. In addition, in planar view, the current injection region 11A does not have to be provided at substantially the center of the first cladding layer 11. For example, in the image display apparatus 100 described later, the light emitting device 1 to be disposed at a periphery of a display region 100A may be designed to change a maximum radiation angle by offsetting a pitch of the current injection region 11A and the light collecting structure (for example, the lens 13L) from a center of the light emitting device 1. This makes it possible to correct an in-plane variation in light collection efficiency resulting from aberration on the lens side that receives an image from the light emitting device 1.

The active layer 12 releases and amplifies spontaneous emission light, thereby causing a radiation recombination of a hole and an electron injected from the first electrode 14 and the second electrode 15 to generate stimulated emission light. For example, the active layer 12 includes a multiple quantum well (MQW) structure in which a plurality of layers including a quantum well layer (not illustrated) and a barrier layer (not illustrated) is alternately laminated. The active layer 12 includes a light emitting region therein in accordance with the current narrowing structure.

The second cladding layer 13 corresponds to one specific example of a "second compound semiconductor layer" of the present disclosure and includes, for example, a p-type GaN-based compound semiconductor material. Of the second cladding layer 13, the surface 13S2 that is on an opposite side of the surface 13S1 facing the active layer 12 is the light exit surface, and a light collecting structure is provided on the surface 13S2. The light collecting structure is a convex lens 13L, for example.

For example, it is sufficient that the lens 13L has a pitch equal to or smaller than a pitch (color pixel pitch) of each of color pixels Pr, Pg, and Pb included in the display pixel P in the image display apparatus 100 described later. Specifically, as illustrated in FIG. 1, for example, the lens 13L may have an outer diameter that is approximately the same as an outer diameter of the light emitting device 1 or may have an outer diameter smaller than the outer diameter of the light emitting device 1 as illustrated in FIG. 2, for example. The lens 13L includes the same material as the second cladding layer 13, and it is possible to form the lens 13L by etching the second cladding layer 13, for example.

The first electrode 14 is in contact with the first cladding layer 11 and is also electrically coupled to the first cladding layer 11. In other words, the first electrode 14 has an ohmic contact with the first cladding layer 11. For example, the first electrode 14 is a metal electrode and includes a multilayer film (Ni/Au) of nickel (Ni) and gold (Au), for example. Other than this, the first electrode 14 may be formed using a transparent conductive material such as indium tin oxide (ITO), for example.

The second electrode 15 is in contact with the second cladding layer 13 and is also electrically coupled to the second cladding layer 13. In other words, the second electrode 15 has an ohmic contact with the second cladding layer 13. The second electrode 125 is formed using a transparent conductive material such as ITO, for example.

### [Method of Manufacturing Light Emitting Device]

For example, it is possible to manufacture the light emitting device 1 in the following manner. FIGs. 4A to 4E illustrate an example of a manufacturing process of the light emitting device 1.

First, as illustrated in FIG. 4A, the second cladding layer 13, the active layer 12, and the first cladding layer 11 are formed by laminating in this order. For example, it is possible to form each of the first cladding layer 11, the active layer 12, and the second cladding layer 13 by epitaxial crystal growth using a method such as metal organic chemical vapor deposition (MOCVD: Metal Organic Chemical Vapor Deposition) or molecular beam epitaxy (MBE: Molecular Beam Epitaxy).

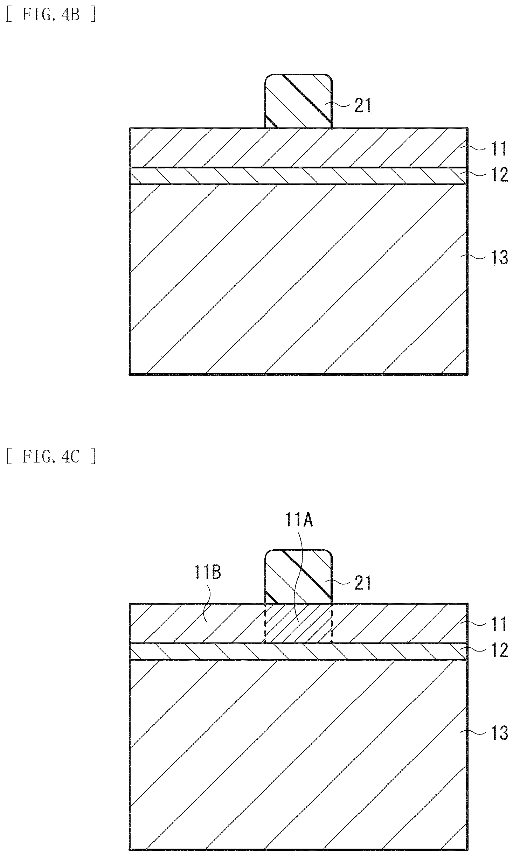

Next, as illustrated in FIG. 4B, a resist film 21 is formed on the first cladding layer 11 in a predetermined pattern. Subsequently, as illustrated in FIG. 4C, for example, the current narrowing region 11B is formed by controlling, by ion implantation, an impurity concentration of the first cladding layer 11 that is exposed from the resist film 21. Then, the resist film 21 is removed, to form the first electrode 14 on the first cladding layer 11.

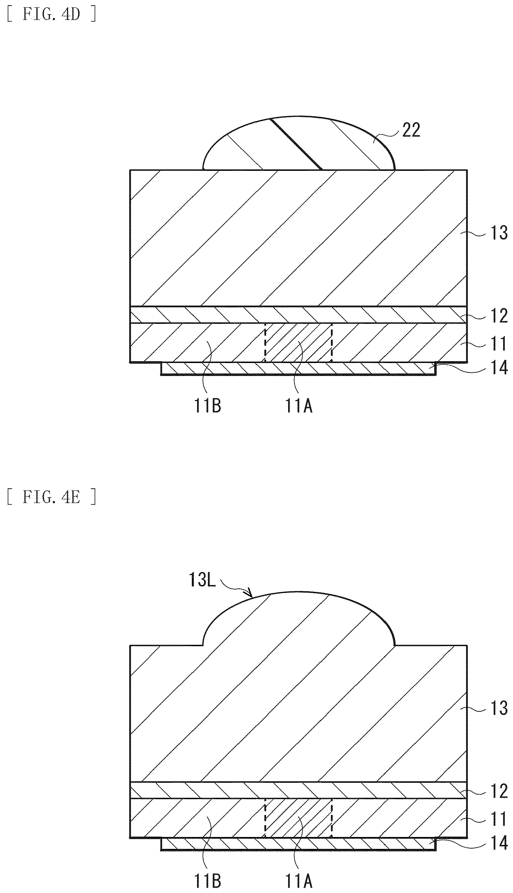

Next, as illustrated in FIG. 4D, a resist film 22 having a desired lens shape is formed on the second cladding layer 13. Subsequently, as illustrated in FIG. 4E, the second cladding layer 13 is processed by etching using the resist film 22 as a mask, for example. This results in formation of the lens 13L having a convex shape on a surface of the second cladding layer 13, for example. Then, the second electrode 15 is formed on the second cladding layer 13. Thus, the light emitting device 1 illustrated in FIGs. 1 and 2 is completed.

### [Configuration of Light Emitting Unit]

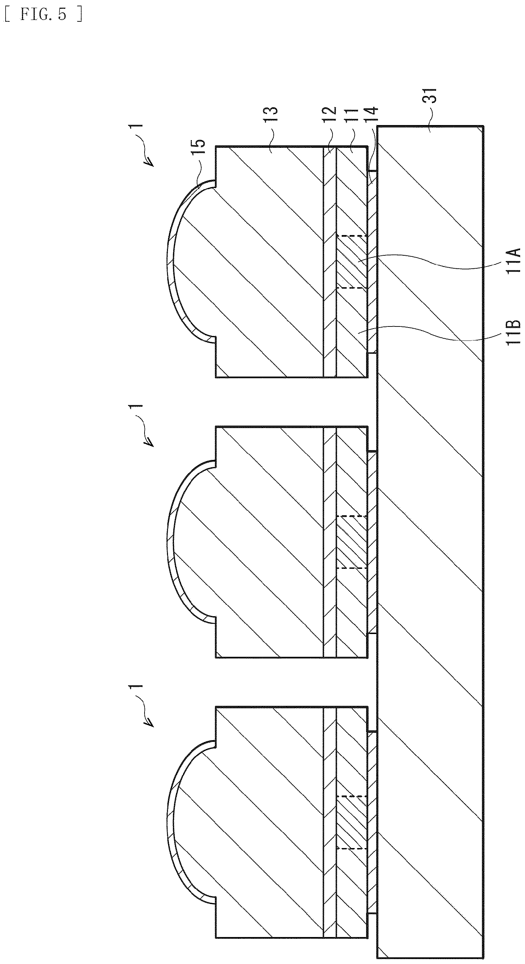

In the image display apparatus 100 described later, a plurality of light emitting devices 1 is arranged in a two-dimensional array in the display region 100A. For example, FIG. 5 schematically illustrates a cross-sectional configuration of light emitting units provided for each display pixel P in the image display apparatus 100.

For example, a light emitting unit includes a plurality of light emitting devices 1 arranged in a row. The light emitting unit has, for example, an elongated shape extending in an arrangement direction of the plurality of light emitting devices 1. The display pixel P in the image display apparatus 100 includes three color pixels Pr, Pg, and Pb arranged at a pitch of 20 µm or less and corresponding to, for example, RGB. In the light emitting unit, for example, three light emitting devices 1 are mounted in a row on a drive substrate 31 to provide one light emitting device 1 for each color pixel Pr, Pg, and Pb.

### [Workings and Effects]

In this light emitting device 1 of the present embodiment, the lens 13L is provided by processing the light exit surface (surface 13S2) of the second cladding layer 13 that is laminated in an order of the first cladding layer 11, the active layer 12, and the second cladding layer 13 while the current injection region 11A and the current narrowing region 11B are provided in the first cladding layer 11. This limits the light emitting region of the active layer 12 and, for example, increases a proportion of light entering an acceptance angle (for example, about ±10°) of the lens 13L that allows light collection in a substantially frontal direction. This will be described in the following.

In a micro-sized panel light source (hereinafter referred to as a microdisplay) used in an organic electroluminescent (EL) display or the like, a lens is used to increase light collection efficiency, to effectively utilize the light emitted from a small light source.

A micro-sized light emitting diode (LED) has high luminance and is effective as a light source for a microdisplay. However, the smaller the device size of the LED, the greater a contribution of a non-emitting end surface, causing a significant decrease in light extraction efficiency.

In a display having a small pixel pitch size such as a microdisplay, it is difficult to provide a lens having a large diameter due to a restriction on pitch size. This causes a size of the lens and a size of the light source (LED) to be close to each other, reducing the light collection effect. In particular, a periphery of a red LED deteriorates significantly. To avoid deterioration of the periphery, a method of increasing device size (an area of the active layer) is employed, but for a microdisplay, it is difficult to employ the above method due to the restriction on pitch size.

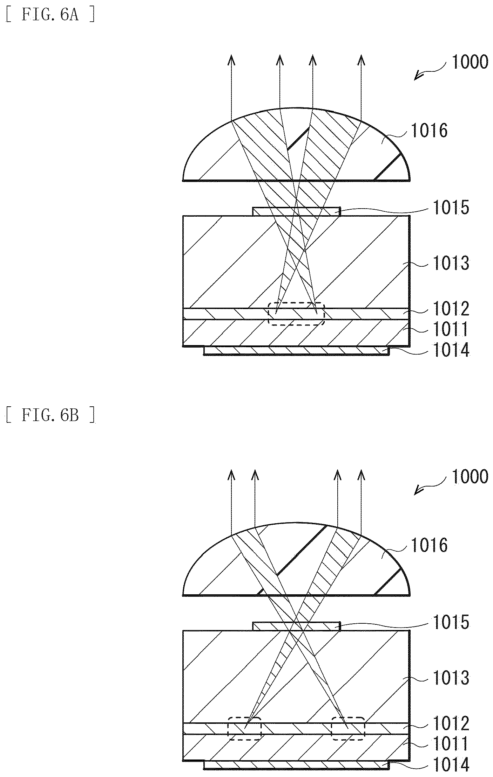

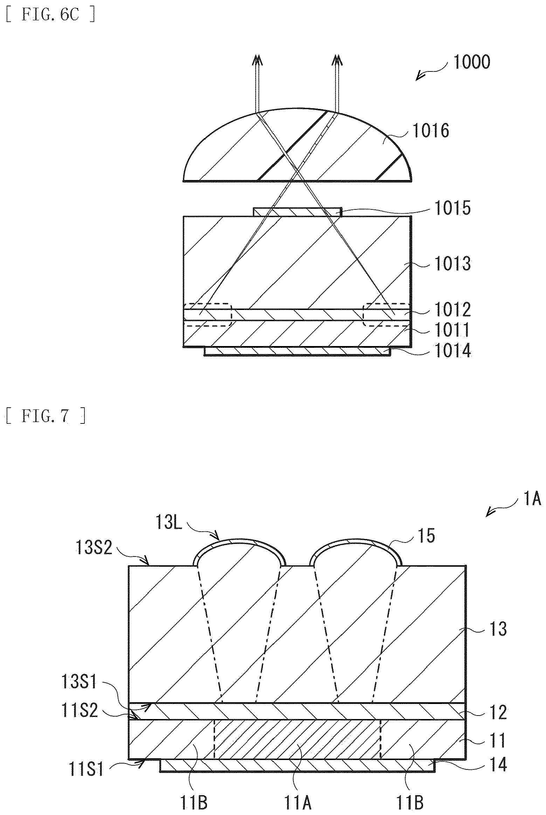

As described above, FIGs. 6A to 6C illustrate a light collection effect depending on a light emission position of a general light emitting device 1000 in which the lens 1016 and the light source (active layer 1012) have substantially the same size. In the general light emitting device 1000, a first electrode 1014 and a second electrode 1015 are formed with a semiconductor laminated body in between, in which a first cladding layer 1011, an active layer 1012, and a second cladding layer 1013 are laminated in order, and a lens 1016 is provided above the second electrode 1015, for example. In such a light emitting device 1000, for example, as illustrated in FIG. 6A, although light emitted at substantially a center of the active layer 1012 is efficiently extracted in a frontal direction by the lens 1016, the amount of the light extracted in the frontal direction decreases as the light travels outward as illustrated in FIG. 6B and FIG. 6C.

Meanwhile, in a semiconductor laser (LD) as represented by a vertical cavity surface emitting laser (VCSEL), a device structure using a lens and a current narrowing structure has been proposed. However, the light emitted from the active layer of the LD becomes coherent light due to a cavity. A spread of this coherent light is related to a lasing parameter such as cavity length, and does not change even if narrowing size of the active layer is limited. Thus, it is difficult to obtain a similar effect even if the technology in the LD is applied to the LED that emits incoherent light.

Whereas, in the present embodiment, the lens 13L is provided by processing the light exit surface (surface 13S2) of the second cladding layer 13 that is laminated in an order of the first cladding layer 11, the active layer 12, and the second cladding layer 13, the current injection region 11A and the current narrowing region 11B are provided in the first cladding layer 11, to limit the light emission region of the active layer 12 to, for example, a focal point of the lens 13L and an adjacent portion thereof where the lens 13L has a high light collection efficiency. This increases a proportion of light entering the acceptance angle of the lens 13L.

In the manner described above, for the light emitting device 1 of the present embodiment, it becomes possible to increase the light extraction efficiency.

In addition, as described above, the smaller the device size of the LED, the greater a ratio of non-radiation recombination at an end surface, and this results in a significant decrease in power efficiency. Whereas, in the present embodiment, for example, as the above-described current narrowing structure, the current injection region 11A and the current narrowing region 11B are provided in the first cladding layer 11 to limit the light emitting region of the active layer 12, thus making it possible to improve power efficiency.

Furthermore, in the present embodiment, the second cladding layer 13 is processed to provide the lens 13L on the surface 13S2 of the second cladding layer 13. Compared with a case where the lens is separately provided above the light emitting device, this reduces a boundary reflection loss at a crystal and a lens surface, and a distance between the lens and the light emitting point. In addition, this also allows a reduction of manufacturing process and device size (miniaturization). Furthermore, using as is, as the lens 13L, the second cladding layer 13 formed by epitaxial crystal growth makes is possible to capture light from a wide angle due to a large refractive index thereof. Accordingly, it becomes possible to reduce a decrease in efficiency due to Fresnel reflection that occurs between the lens and the LED in a general light emitting device (for example, the light emitting device 1000).

Next, Modification Examples 1 to 8 of the present disclosure will be described. It is to be noted that components corresponding to the light emitting device 1 of the above embodiment will be denoted by the same reference numerals and the description thereof will be omitted.

### <2. Modification Example 1>

FIG. 7 schematically illustrates an example of a cross-sectional configuration of a light emitting device 1A according to Modification Example 1 of the present disclosure. As with the light emitting device 1 in the above embodiment, the light emitting device 1A is preferably used in, for example, the display pixel P in the image display apparatus 100.

In the above embodiment, in one light emitting device 1, an example of providing one lens 13L on the surface 1351 of the second cladding layer 13 has been described, but this is not limitative. For example, as illustrated in FIG. 7, two or more lenses 13L may be provided on the surface 13S1 of the second cladding layer 13 in the one light emitting device 1A.

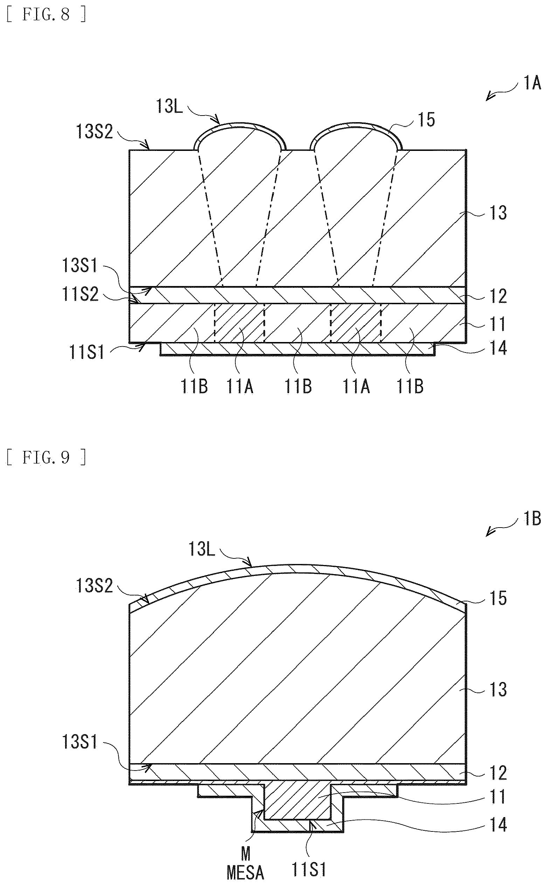

In addition, in a case of providing a plurality of lenses 13L, a plurality of current injection regions 11A may be provided in accordance with the number of lenses 13L as illustrated in FIG. 8, for example. This limits the light emitting region of the active layer 12 to the focal point and an adjacent portion thereof in each of the plurality of lenses 13L.

Thus, in the present modification example, one light emitting device 1 includes a plurality of lenses 13L, thus making it possible to efficiently use a portion with a high injection efficiency in addition to the effect of the above embodiment.

### <3. Modification Example 2>

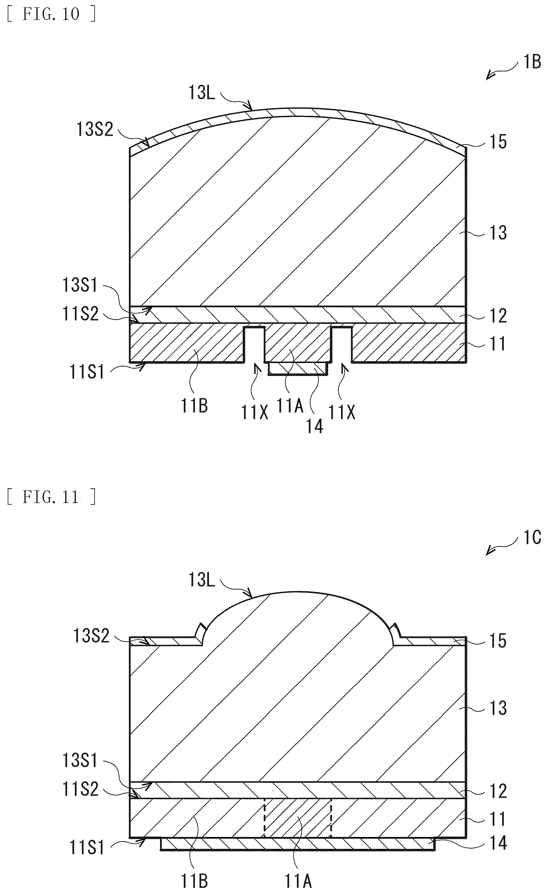

FIG. 9 schematically illustrates an example of a cross-sectional configuration of a light emitting device 1B according to Modification Example 2 of the present disclosure. FIG. 10 schematically illustrates another example of the cross-sectional configuration of the light emitting device 1B according to Modification Example 2 of the present disclosure. As with the light emitting device 1 in the above embodiment, the light emitting device 1B is preferably used in, for example, the display pixel P in the image display apparatus 100.

As illustrated in FIG. 9, for example, the current narrowing structure may include a mesa M formed by grinding a periphery of the first cladding layer 11. Alternatively, as illustrated in FIG. 10, for example, the current narrowing structure may be configured to have a groove 11X surrounding a desired region (for example, substantially a center portion) of the first cladding layer 11, and include the first electrode 14 on the surface 11S1 of the first cladding layer 11 inside the groove 11X.

Thus, in the present modification example, the first cladding layer 11a has the mesa M or groove 11X, thereby mechanically narrowing an electric current injected from the first electrode 14 to the active layer 12. This makes it possible to obtain the same effect as in the above embodiment.

### <4. Modification Example 3>

FIG. 11 schematically illustrates an example of a cross-sectional configuration of a light emitting device 1C according to Modification Example 3 of the present disclosure. As with the light emitting device 1 in the above embodiment, the light emitting device 1C is preferably used in, for example, the display pixel P in the image display apparatus 100.

In the above embodiment, an example of providing the second electrode 15 to cover the lens 13L has been illustrated. However, as illustrated in FIG. 11, for example, the second electrode 15 may be provided on a flat surface 13S2 of the second cladding layer 13 around the lens 13L. In that case, it is possible to form the second electrode 15, for example, as a metal electrode such as a multilayer film (Ti/Al) including titanium (Ti) and aluminum (Al) or a multilayer film (Cr/Au) including chromium (Cr) and gold (Au).

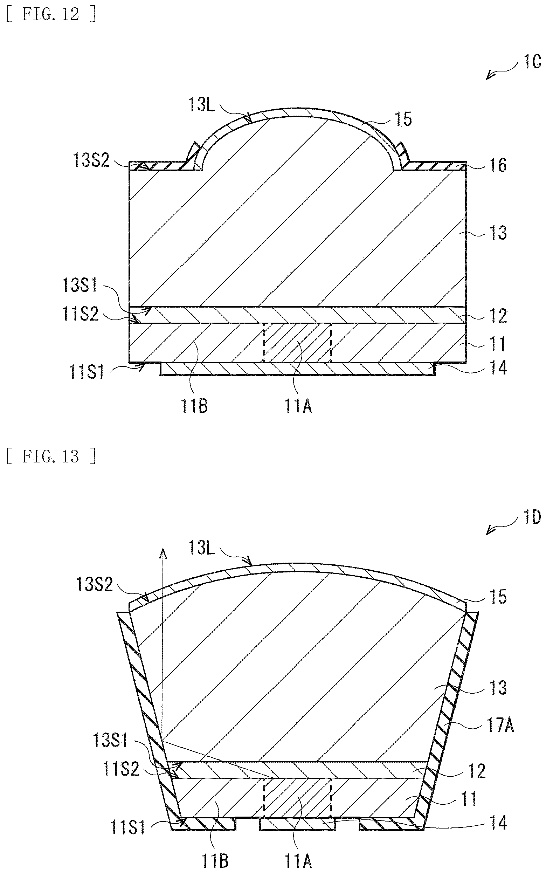

In addition, as in the above embodiment, in a case of providing the second electrode 15 on the lens 13L, a light reflection film 16 may be formed on the flat surface 13 S2 of the second cladding layer 13 around the lens 13L as illustrated in FIG. 12, for example. It is preferable that the light reflection film 16 be formed using a material having a high reflectivity for light emitted in the active layer 12 regardless of an angle of incidence. Such a material includes gold (Au), silver (Ag), aluminum (Al), and platinum (Pt). Other than this, for example, titanium (Ti), copper (Cu), or nickel (Ni), or an alloy thereof may be used.

Thus, in the present modification example, a metal electrode is provided as the second electrode 15 on the flat surface 13 S2 of the second cladding layer 13 around the lens 13L. In addition, in a case of providing the second electrode 15 on the lens 13L, the light reflection film 16 is formed on the flat surface 13 S2 of the second cladding layer 13 around the lens 13L. This causes the light entering the surface 13 S2 of the second cladding layer 13 except for the lens 13L portion to be reflected by the second electrode 15 or the light reflection film 16, resulting in an increase in a probability of the light entering the acceptance angle of the lens 13L. Accordingly, compared with the above embodiment, it becomes possible to increase light extraction efficiency.

### <5. Modification Example 4>

FIG. 13 schematically illustrates an example of a cross-sectional configuration of a light emitting device 1D according to Modification Example 4 of the present disclosure. As with the light emitting device 1 in the above embodiment, the light emitting device 1D is preferably used in, for example, the display pixel P in the image display apparatus 100.

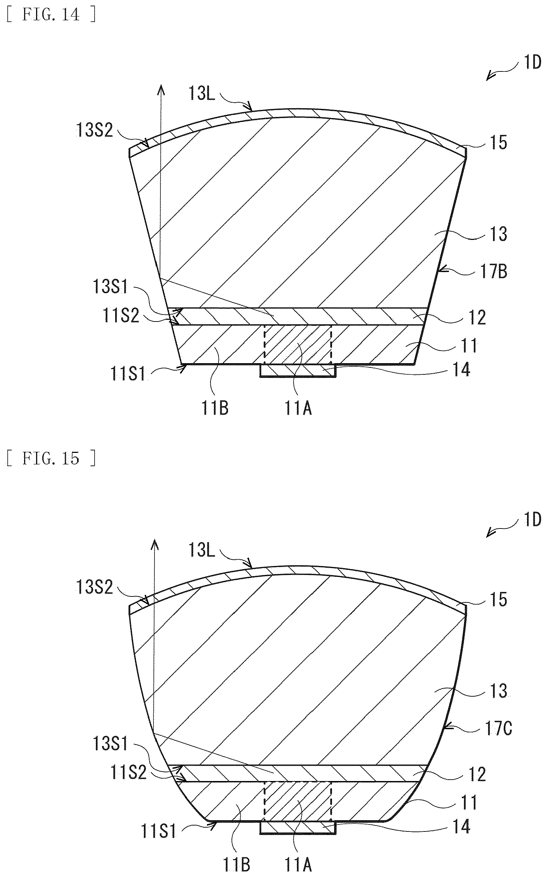

The light emitting device 1D of the present modification example differs from the light emitting device 1 of the above embodiment in that a mirror structure is provided on a lateral surface. Specifically, for example, as illustrated in FIG. 13, a lateral surface of the light emitting device 1D may be an inclined surface that continues from the first cladding layer 11 to the second cladding layer 13 and a surrounding portion thereof may be covered with a light reflecting film 17A. Other than this, as illustrated in FIG. 14, for example, the lateral surface of the light emitting device 1D may include a mirror structure. Alternatively, as illustrated in FIG. 15, for example, the lateral surface of the light emitting device 1D may include a parabolic mirror structure. Alternatively, the lateral surface of the light emitting device 1D may include a Fresnel mirror structure.

Thus, in the present modification example, due to the mirror structure included in the lateral surface of the light emitting device 1D, out of the light emitted in the active layer 12, light that does not travel toward the light exit surface (surface 13S2) side as indicated by arrow in FIGs. 13 to 15 is repeatedly reflected by the mirror structure in the lateral surface of the light emitting device 1D, and is finally directed to the light exit surface (surface 13S2) to be extracted from the lens 13L. Accordingly, compared with the above embodiment, it is possible to further increase light extraction efficiency.

### <6. Modification Example 5>

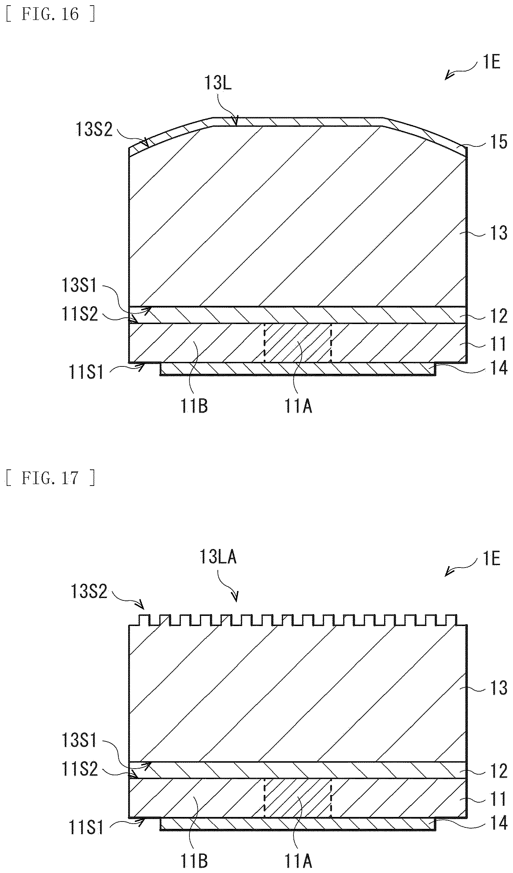

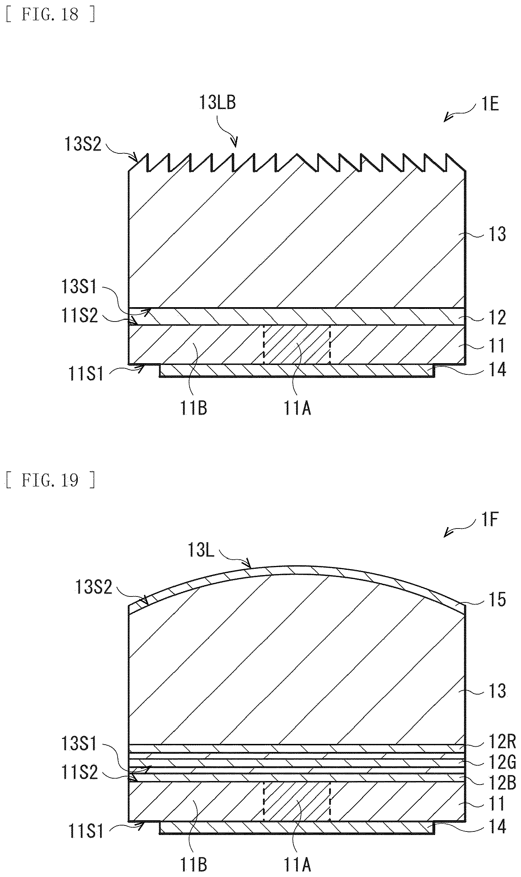

FIG. 16 schematically illustrates an example of a cross-sectional configuration of a light emitting device 1E according to Modification Example 5 of the present disclosure. FIG. 17 schematically illustrates another example of the cross-sectional configuration of the light emitting device 1E according to Modification Example 5 of the present disclosure. FIG. 18 schematically illustrates another example of the cross-sectional configuration of the light emitting device 1E according to Modification Example 5 of the present disclosure. As with the light emitting device 1 in the above embodiment, the light emitting device 1E is preferably used in, for example, the display pixel P in the image display apparatus 100.

In the above embodiment, as the light collecting structure, an example of forming the convex lens 13L on the surface 13L2 of the second cladding layer 13 has been described, but the shape of the lens 13L is not limited to this. For example, as illustrated in FIG. 16, a portion of the surface of lens 13L may be a flat surface. Alternatively, the light collecting structure may include a nanoantenna 13LA as illustrated in FIG. 17, for example, or may include a Fresnel lens 13LB as illustrated in FIG. 18, for example, thus making it possible to obtain the same effect as in the above embodiment.

### <7. Modification Example 6>

FIG. 19 schematically illustrates an example of a cross-sectional configuration of a light emitting device 1F according to Modification Example 6 of the present disclosure. As with the light emitting device 1 in the above embodiment, the light emitting device 1F is preferably used in, for example, the display pixel P in the image display apparatus 100.

As illustrated in FIG. 19, for example, the active layer 12 may include a plurality of layers 12R, 12G, and 12B emitting light corresponding respectively to RGB (red light Lr, green light Lg, and blue light Lb), for example.

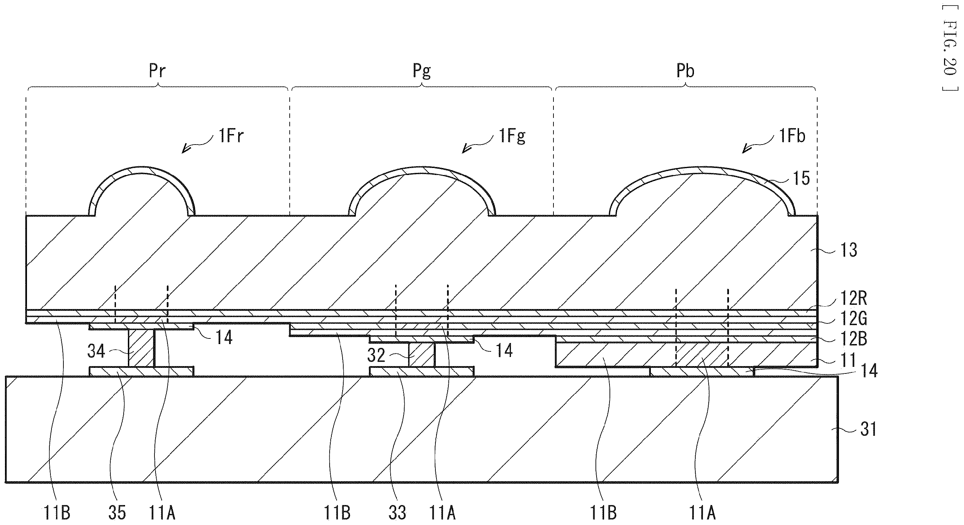

FIG. 20 schematically illustrates a cross-sectional configuration of a light emitting unit using the light emitting device 1F illustrated in FIG. 19. In the light emitting unit illustrated in FIG. 20, light emitting devices 1Fr, 1Fg, and 1Fb corresponding to RGB are arranged in a row.

In the light emitting device 1F, for example, a layer 12B that emits blue light Lb, a layer 12G that emits green light Lg, and a layer 12R that emits red light Lr are laminated in this order. Between each of the layers 12B, 12G, and 12R, for example, a compound semiconductor layer having the same configuration as the first cladding layer 11 is provided. In the light emitting unit illustrated in FIG. 20, the light emitting devices 1Fr, 1Fg, and 1Fb provided respectively for the color pixels Pr, Pg, and Pb include a continuous semiconductor layer. In detail, in the color pixel Pb, there is provided the light emitting device 1Fb to include the first cladding layer 11, the active layer 12 including the layers 12B, 12G, and 12R, and the second cladding layer 13. The light emitting device 1Fb is mounted on the drive substrate 31 via the first electrode 14. In the color pixel Pg, with the first cladding layer 11 and the layer 12B removed, there is provided the light emitting device 1Fg in which the compound semiconductor layer between the layers 12B and 12G serves as the first cladding layer 11. The light emitting device 1Fg is mounted on the drive substrate 31 via the first electrode 14, a bump 32, and a pad electrode 33. In the color pixel Pr, with the layers 12B and 12G removed, there is provided the light emitting device 1Fr in which the compound semiconductor layer between the layers 12G and 12R serves as the first cladding layer 11. The light emitting device 1Fr is mounted on the drive substrate 31 via the first electrode 14, a bump 34, and a pad electrode 35. In the light emitting unit illustrated in FIG. 20, the layer 12R and the second cladding layer 13 are formed over the light emitting devices 1Fr, 1Fg, and 1Fb as a common layer.

It is to be noted that in a case of providing, in each color pixel Pr, Pg, and Pb, a light emitting device in which a plurality of layers 12R, 12G, and 12B corresponding to RGB is laminated, it is preferable that the lens 13L provided on the surface 13S2 of the second compound semiconductor layer have a focal point at a position of each layer 12R, 12G, and 12B as illustrated in FIG. 20.

In addition, FIG. 20 illustrates an example in which the light emitting device 1Fr, the light emitting device 1Fg, and the light emitting device 1F are arranged in a row in this order, but the position of each of the light emitting devices 1Fr, 1Fg, and 1F in the light emitting unit is not limited to this. Furthermore, FIG. 20 illustrates an example in which the light emitting devices 1Fg and 1Fr are mounted on a mounting substrate via the bumps 32 and 34 and the pad electrodes 33 and 35, respectively. However, in the mounting to the drive substrate 31, another bonding method such as Cu-Cu bonding may be used, for example.

### <8. Modification Example 7>

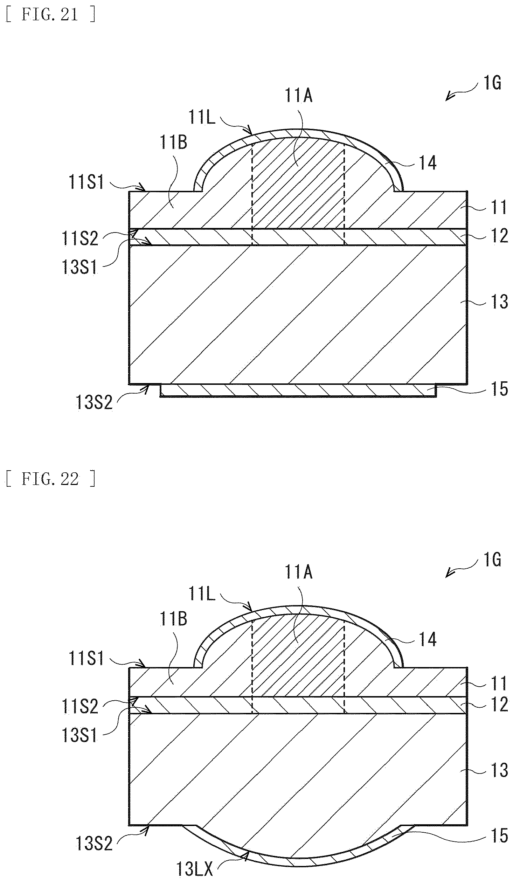

FIG. 21 schematically illustrates an example of a cross-sectional configuration of a light emitting device 1G according to Modification Example 7 of the present disclosure. As with the light emitting device 1 in the above embodiment, the light emitting device 1G is preferably used in, for example, the display pixel P in the image display apparatus 100.

In the above embodiment, for example, an example has been illustrated in which the light is extracted from the side of the second cladding layer 13 that includes a p-type GaN-based compound semiconductor material, but this not limitative. For example, as illustrated in FIG. 21, a lens 11L may be provided on the surface 11S1 of the first cladding layer 11 that includes an n-type GaN-based compound semiconductor material, to extract the light from the first cladding layer 11 side.

In addition, as illustrated in FIG. 21, for example, the current narrowing structure may be provided on the light exit surface (surface 11S1) side. In the present modification example, the second cladding layer 13 corresponds to the "first compound semiconductor layer" of the present disclosure, and the first cladding layer 11 corresponds to the "second compound semiconductor layer" of the present disclosure.

Furthermore, as illustrated in FIG. 22, for example, a concave mirror structure 13LX may be provided on an opposite side of the light exit surface (surface 11S1), for example, on the surface 13S2 of the second cladding layer 13. This makes it possible to efficiently reflect the light travelling toward the opposite side of the light exit surface (surface 11S1) side, back to the light exit surface (surface 11S1) side.

### <9. Modification Example 8>

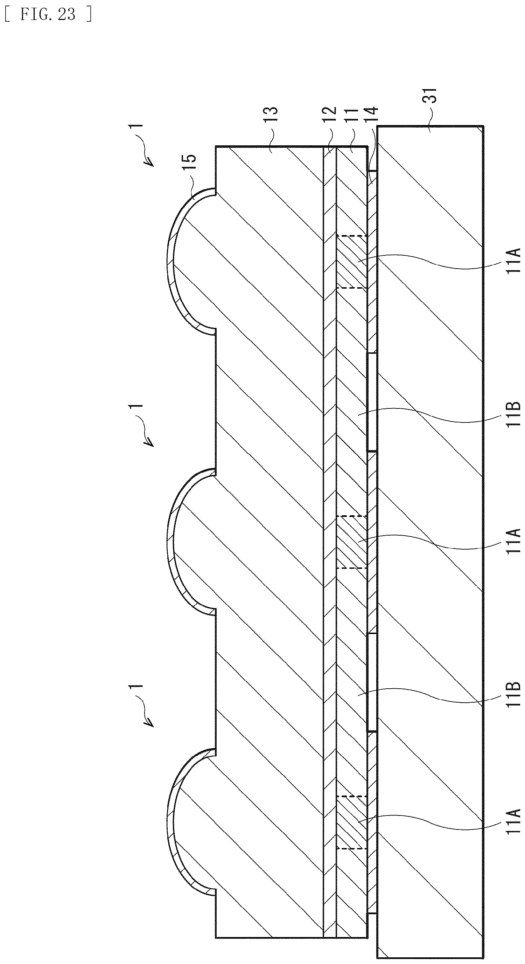

FIG. 23 schematically illustrates an example of a cross-sectional configuration of a light emitting unit according to Modification Example 7 of the present disclosure. In the above embodiment, an example has been illustrated in which three light emitting devices 1 separated from each other are mounted on the drive substrate 31 to be included in the light emitting unit. The first cladding layer 11, the active layer 12, and the second cladding layer 13 included in these three light emitting devices may be continuous to each other as a common layer for the three light emitting devices. This makes it possible to reduce an occurrence of absence of emission on an end surface due to peripheral degradation.

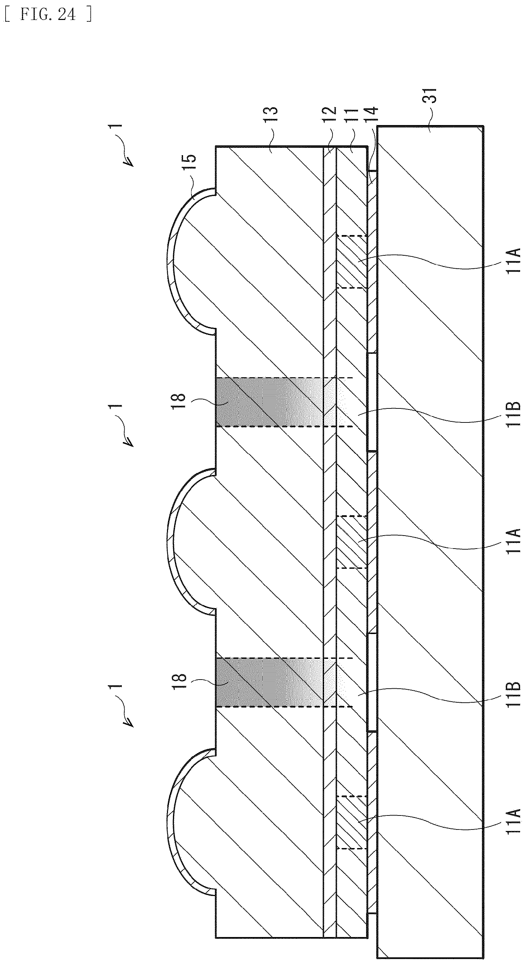

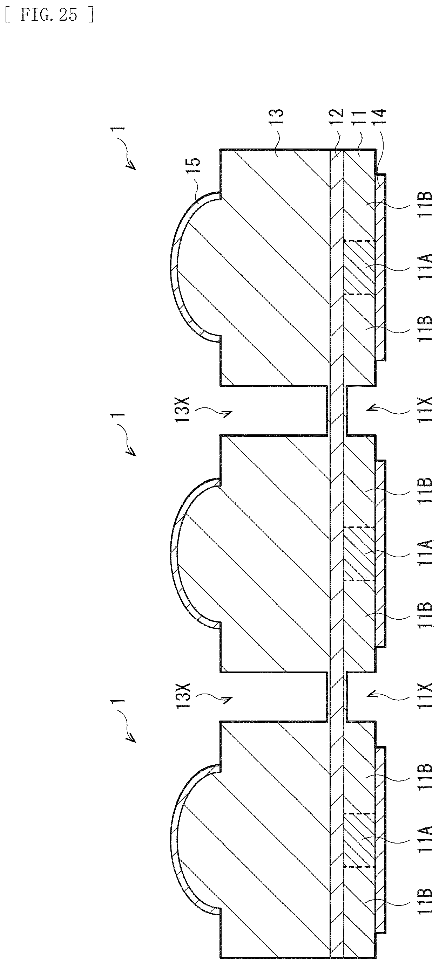

In addition, in a case of using the first cladding layer 11, the active layer 12, and the second cladding layer 13 as a common layer for a plurality of light emitting devices as illustrated in FIG. 23, a separation region 18 may be provided to electrically or optically separate adjacent light emitting devices as illustrated in FIG. 24, for example. For example, it is possible to form the separation region 18 by injecting hydrogen, boron, or the like from the second cladding layer 13 side. Other than this, as illustrated in FIG. 25, for example, the first cladding layer 11 and the second cladding layer 13 may have grooves 11X and 13X, respectively, to be electrically separated from each other while the active layer 12 is left as is, for example.

### <10. Application Example 1>

FIG. 26 is a perspective view illustrating an example of a schematic configuration of an image display apparatus (image display apparatus 100). In the image display apparatus 100, a light emitting device (for example, the light emitting device 1) of the present disclosure is used for the display pixel P. As illustrated in FIG. 26, for example, the image display apparatus 100 includes a display panel 110 and a control circuit 140 that drives the display panel 110.

The display panel 110 includes a mounting substrate 120 and a transparent substrate 130 superimposed on each other. The transparent substrate 130 has a surface as a picture display surface, and includes a display region 100A in a central portion and a frame region 100B as a non-display region around the display region 100A.

FIG. 27 illustrates an example of a wiring layout in a region corresponding to the display region 100A out of the surface on the transparent substrate 130 side of the mounting substrate 120. In the region corresponding to the display region 100A out of the surface of the mounting substrate 120, as illustrated in FIG. 27, for example, a plurality of data wiring lines 1021 is formed to extend in a predetermined direction and arranged in parallel at a predetermined pitch. Furthermore, for example, out of the surface of the mounting substrate 120, in a region corresponding to the display region 100A, a plurality of scan wiring lines 1022 is formed to extend in a direction intersecting (for example, orthogonal to) the data wiring lines 1021 while being arranged in parallel at a predetermined pitch. The data wiring lines 1021 and the scan wiring lines 1022 include a conductive material such as Cu, for example.

For example, the scan wiring lines 1022 are formed on an outermost surface layer, and are formed, for example, on an insulating layer (not illustrated) formed on a surface of a base material. It is to be noted that the base material of the mounting substrate 120 includes, for example, a silicon substrate or a resin substrate or the like, and the insulating layer on the base material includes, for example, SiN, SiO, aluminum oxide (AlO) or a resin material. On the other hand, the data wiring lines 1021 are formed in a layer different from the outermost layer including the scan wiring lines 1022 (for example, a layer lower than the outermost layer), for example, in the insulating layer on the base material.

A portion adjacent to the intersection between the data wiring lines 1021 and the scan wiring line 1022 is the display pixel P, and a plurality of display pixels P is arranged in a matrix, for example, in the display region 100A. Each display pixel P includes color pixels Pr, Pg, and Pb corresponding to RGB, for example, and each color pixel Pr, Pg, and Pb is mounted with a corresponding one of the light emitting devices 1R, 1G, and 1B. FIG. 27 illustrates a case where a single display pixel P includes three light emitting devices 1R, 1G, and 1B, allowing red light to be outputted from the light emitting device 1R, green light to be outputted from the light emitting device 1G, and blue light to be outputted from the light emitting device 1B.

For example, the light emitting device 1 is provided with a pair of terminal electrodes for each color pixel Pr, Pg, and Pb, or with one terminal electrode shared in common and the other for each color pixel Pr, Pg, and Pb. Then, one terminal electrode is electrically coupled to the data wiring line 1021, and the other terminal electrode is electrically coupled to the scan wiring line 1022. For example, one terminal electrode is electrically coupled to a pad electrode 1021B at a tip of a branch 1021A provided in the data wiring lines 1021. In addition, for example, the other terminal electrode is electrically coupled to a pad electrode 1022B at a tip of a branch 1022A provided in the scan wiring lines 1022.

For example, the pad electrodes 1021B and 1022B are formed on the outermost surface layer, at a site in which the light emitting device 1 is mounted as illustrated in FIG. 27. Here, for example, the pad electrodes 121B and 122B include a conductive material such as Au (gold).

The mounting substrate 120 is further provided with, for example, a plurality of pillars (not illustrated) that regulate spacing between the mounting substrate 120 and the transparent substrate 130. The pillars may be provided within an opposing region to the display region 100A or within an opposing region to the frame region 100B.

The transparent substrate 130 includes, for example, a glass substrate or a resin substrate. The transparent substrate 130 may have a flat surface on the light emitting device 1 side, but it is preferable that the surface be a rough surface. The rough surface may be provided across the entire opposing region to the display region 100A or only in the opposing region to the display pixel P. The rough surface has fine unevenness to allow light emitted from the color pixels Pr, Pg, and Pb to enter the rough surface. It is possible to create the unevenness of the rough surface by sandblasting or dry etching, for example.

The control circuit 140 drives each display pixel P (each light emitting device 1) on the basis of a picture signal. The control circuit 140 includes, for example, a data driver that drives each data wiring line 1021 coupled to the display pixel P and a scan driver that drives each scan wiring line 1022 coupled to the display pixel P. For example, as illustrated in FIG. 26, the control circuit 140 may be provided separately from the display panel 110 and coupled to the mounting substrate 120 via wiring, or may be mounted on the mounting substrate 120.

It is to be noted that the image display apparatus 100 illustrated in FIG. 26 is one example of a passive matrix type image display apparatus. The light emitting device 1 of the present embodiment is applicable not only to a passive matrix type image display apparatus (image display apparatus 100), but also to an active matrix type image display apparatus. It is to be noted that for an active matrix type image display apparatus, for example, it is not necessary to include the frame region 100B illustrated in FIG. 26.

### <11. Application Example 2>

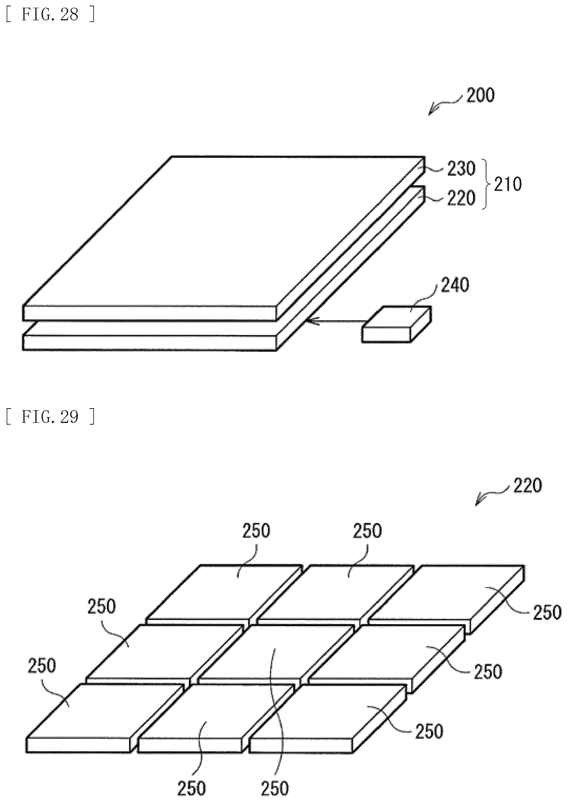

FIG. 28 is a perspective view illustrating another configuration example of an image display apparatus (image display apparatus 200) using the light emitting device (for example, the light emitting device 1) of the present disclosure. The image display apparatus 200 is what is called a tiling display. As illustrated in FIG. 28, the image display apparatus 200 includes, for example, a display panel 210 and a control circuit 240 that drives the display panel 210.

The display panel 210 includes a mounting substrate 220 and an opposing substrate 230 superimposed on each other. The opposing substrate 230 has a surface as a picture display surface, and includes a display region in a central portion and a frame region as a non-display region around the display region (none of which is illustrated). For example, the opposing substrate 230 is disposed at a position opposed to the mounting substrate 220 via a predetermined gap. The opposing substrate 230 may be in contact with an upper surface of the mounting substrate 220.

FIG. 29 schematically illustrates an example of a configuration of the mounting substrate 220. As illustrated in FIG. 29, for example, the mounting substrate 220 includes a plurality of unit substrates 250 laid out in a tiled pattern. It is to be noted that FIG. 29 illustrates an example of the mounting substrate 220 that includes nine unit substrates 250, but the number of the unit substrates 250 may be 10 or more, or may be eight or less.

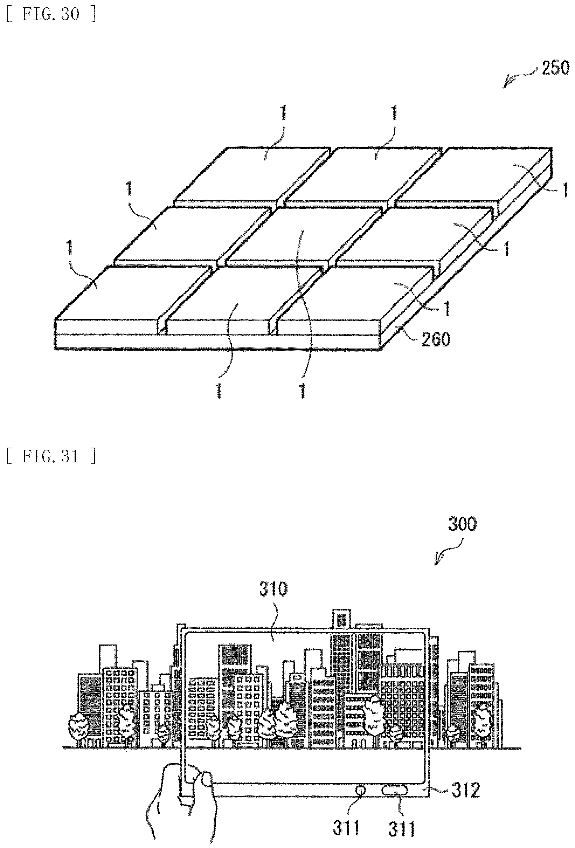

FIG. 30 illustrates an example of a configuration of the unit substrate 250. The unit substrate 250 includes, for example, a plurality of light emitting devices 1 laid out in a tiled pattern and a support substrate 260 that supports each light emitting device 1. Each unit substrate 250 further includes a control substrate (not illustrated). The support substrate 260 includes, for example, a metal frame (metal plate) or a wiring substrate, or the like. In a case where the support substrate 260 includes a wiring substrate, it is possible for the wiring substrate to serve as the control substrate. At this time, the support substrate 260, the control substrate, or both is electrically coupled to each light emitting device 1.

### <12. Application Example 3>

FIG. 31 illustrates an appearance of a transparent display 300. The transparent display 300 includes, for example, a display section 310, a control section 311, and a housing 312. In the display section 310, the light emitting device (for example, the light emitting device 1) of the present disclosure is used. This transparent display 300 is able to display an image or text information with a transparent background in the display section 310.

In the transparent display 300, a substrate having light transparency is used for the mounting substrate. As with the mounting substrate, each electrode provided in the light emitting device 1 includes a conductive material having light transparency. Alternatively, each electrode is configured to be less visible by adding a wiring width or reducing a wiring thickness. In addition, the transparent display 300 allows a black display by overlaying a liquid crystal layer including a drive circuit, and allows switching between transmission and the black display by controlling a light distribution direction of the liquid crystal.

The present disclosure has been described above with reference to the embodiment and Modification Examples 1 to 8, and application examples, but the present disclosure is not limited to the above embodiments, etc. and various modifications are possible. For example, two or more of the above Modification Examples 1 to 8 may be combined.

In addition, in the above embodiment and examples, although a light emitting unit that emits light corresponding to RGB has been illustrated, the configuration of the light emitting unit is not limited to this. For example, the light emitting unit may be configured to emit light in two colors such as RG or RB. Alternatively, the light emitting unit may be configured as a light emitting unit that emits light in four or more colors, such as RGBW. Furthermore, for example, FIG. 20 illustrates a light emitting unit that includes, as a single unit, a display pixel P including color pixels Pr, Pg, and Pb, but the configuration of the light emitting unit is not limited to this. The light emitting unit may be configured, for example, with the entire display region 100A of the image display apparatus 100 as a single unit. In that case, the light emitting devices 1Fr, 1Fg, and 1Fb corresponding to color pixels Pr, Pg, and Pb, respectively, are regularly arranged in a mosaic pattern on the drive substrate 31.

It is to be noted that effects described herein are merely illustrative and are not limited to the description, and may have other effects.

It is to be noted that the technique of the present disclosure may have the following configurations. According to the present technique having the following configurations, a light collection structure is provided in a light exit surface of a second semiconductor layer that is laminated in an order of a first compound semiconductor layer, an active layer, and a second compound semiconductor layer, along with a current narrowing structure provided in the first compound semiconductor layer or the second compound semiconductor layer. This limits a light emitting region in the active layer and increases a proportion of light entering an acceptance angle of a lens. Accordingly, it becomes possible to increase light extraction efficiency.
(1) A light emitting device including:
   a first compound semiconductor layer having a first surface and a second surface, the first surface and the second surface being opposed to each other;
   an active layer facing the second surface of the first compound semiconductor layer;
   a second compound semiconductor layer having a third surface and a fourth surface, the second compound semiconductor layer including one or a plurality of light collecting structures on the fourth surface, the third surface facing the active layer, and the fourth surface being opposed to the third surface and serving as a light exit surface; and
   a current narrowing structure provided in the first compound semiconductor layer or the second compound semiconductor layer.
(2) The light emitting device according to (1), in which
   the current narrowing structure includes a current injection region and a current narrowing region, the current narrowing region being provided around the current injection region.
(3) The light emitting device according to (1) or (2), in which
   the current narrowing structure is formed from the first compound semiconductor layer to the second compound semiconductor layer or from the second compound semiconductor layer to the first compound semiconductor layer.
(4) The light emitting device according to (1) or (2), in which
   the current narrowing structure has a groove, the groove being in the first surface of the first compound semiconductor layer, in the fourth surface of the second compound semiconductor layer, or both.
(5) The light emitting device according to (2) or (3), in which
   the current narrowing region in the current narrowing structure includes an impurity region, the impurity region being provided in the first compound semiconductor layer or the second compound semiconductor layer.
(6) The light emitting device according to (2) or (3), in which
   the current narrowing region in the current narrowing structure incudes an oxide layer, the oxide layer being provided in the first compound semiconductor layer or the second compound semiconductor layer.
(7) The light emitting device according to any one of (1) to (6), including a plurality of light emitting regions in the active layer, in which
   the one or the plurality of light collecting structures is provided in the fourth surface corresponding to each of the plurality of light emitting regions.
(8) The light emitting device according to (7), in which
   the active layer is electrically or mechanically separated between each of the plurality of light emitting regions adjacent to each other.
(9) The light emitting device according to any oner of (1) to (8), in which
   the one or the plurality of light collecting structures includes a convex lens, a nanoantenna, or a Fresnel lens, the convex lens, the nanoantenna, or the Fresnel lens being formed in the fourth surface of the second compound semiconductor layer.
(10) The light emitting device according to any one of (1) to (9), further including:
   a first electrode electrically coupled to the first compound semiconductor layer; and
   a second electrode electrically coupled to the second compound semiconductor layer, in which
   the second electrode is laminated on the one or the plurality of light collecting structures.
(11) The light emitting device according to (10), in which
   a light reflection film is laminated on the fourth surface around the one or the plurality of light collecting structures.
(12) The light emitting device according to any one of (1) to (9), further including:
   a first electrode electrically coupled to the first compound semiconductor layer; and
   a second electrode electrically coupled to the second compound semiconductor layer, in which
   the second electrode is provided around the one or the plurality of light collecting structures.
(13) The light emitting device according to any one of (1) to (12), in which
   the first compound semiconductor layer has a mesa shape as the current narrowing structure.
(14) The light emitting device according to any one of (1) to (13), in which
   the first compound semiconductor layer includes a concave mirror structure on the first surface.
(15) The light emitting device according to any one of (1) to (14), in which
   the first compound semiconductor layer, the active layer, and the second compound semiconductor layer have a lateral surface in which a mirror structure is continuously provided.
(16) The light emitting device according to (15), in which
   the mirror structure includes a light reflection film, a Fresnel mirror, or a parabolic mirror.
(17) The light emitting device according to any one of (1) to (16), in which
   the active layer includes a plurality of layers, the plurality of layers emitting light having wavelength bands different from each other.
(18) An image display apparatus, including a plurality of light emitting devices, the plurality of light emitting devices being provided for each of a plurality of pixels arranged in an array, in which
   each of the plurality of light emitting devices includes:
   a first compound semiconductor layer having a first surface and a second surface, the first surface and the second surface being opposed to each other,
   an active layer facing the second surface of the first compound semiconductor layer,
   a second compound semiconductor layer having a third surface and a fourth surface, the second compound semiconductor layer including one or a plurality of light collecting structures in the fourth surface, the third surface facing the active layer, and the fourth surface being opposed to the third surface and becoming a light exit surface, and
   a current narrowing structure provided in the first compound semiconductor layer or the second compound semiconductor layer.
(19) The image display apparatus according to (18), in which
   the plurality of pixels has a pitch of 20 µm or lower.
(20) The image display apparatus according to (18) or (19), in which
   the plurality of light collecting structures has a pitch equal to or lower than the pitch of the plurality of pixels.

This application claims priority based on Japanese Patent Application No. 2021-140413 filed on August 30, 2021 with Japan Patent Office, the entire contents of which are incorporated in this application by reference.

It should be understood by those skilled in the art that various modifications, combinations, sub-combinations and alterations may occur depending on design requirements and other factors insofar as they are within the scope of the appended claims or the equivalents thereof.

## Claims

1. A light emitting device comprising:
a first compound semiconductor layer having a first surface and a second surface, the first surface and the second surface being opposed to each other;
an active layer facing the second surface of the first compound semiconductor layer;
a second compound semiconductor layer having a third surface and a fourth surface, the second compound semiconductor layer including one or a plurality of light collecting structures on the fourth surface, the third surface facing the active layer, and the fourth surface being opposed to the third surface and serving as a light exit surface; and
a current narrowing structure provided in the first compound semiconductor layer or the second compound semiconductor layer.

2. The light emitting device according to claim 1, wherein
the current narrowing structure includes a current injection region and a current narrowing region, the current narrowing region being provided around the current injection region.

3. The light emitting device according to claim 1, wherein
the current narrowing structure is formed from the first compound semiconductor layer to the second compound semiconductor layer or from the second compound semiconductor layer to the first compound semiconductor layer.

4. The light emitting device according to claim 1, wherein
the current narrowing structure has a groove, the groove being in the first surface of the first compound semiconductor layer, in the fourth surface of the second compound semiconductor layer, or both.

5. The light emitting device according to claim 2, wherein
the current narrowing region in the current narrowing structure includes an impurity region, the impurity region being provided in the first compound semiconductor layer or the second compound semiconductor layer.

6. The light emitting device according to claim 2, wherein
the current narrowing region in the current narrowing structure incudes an oxide layer, the oxide layer being provided in the first compound semiconductor layer or the second compound semiconductor layer.

7. The light emitting device according to claim 1, comprising a plurality of light emitting regions in the active layer, wherein
the one or the plurality of light collecting structures is provided in the fourth surface corresponding to each of the plurality of light emitting regions.

8. The light emitting device according to claim 7, wherein
the active layer is electrically or mechanically separated between each of the plurality of light emitting regions adjacent to each other.

9. The light emitting device according to claim 1, wherein
the one or the plurality of light collecting structures includes a convex lens, a nanoantenna, or a Fresnel lens, the convex lens, the nanoantenna, or the Fresnel lens being formed in the fourth surface of the second compound semiconductor layer.

10. The light emitting device according to claim 1, further comprising:
a first electrode electrically coupled to the first compound semiconductor layer; and
a second electrode electrically coupled to the second compound semiconductor layer, wherein
the second electrode is laminated on the one or the plurality of light collecting structures.

11. The light emitting device according to claim 10, wherein
a light reflection film is laminated on the fourth surface around the one or the plurality of light collecting structures.

12. The light emitting device according to claim 1, further comprising:
a first electrode electrically coupled to the first compound semiconductor layer; and
a second electrode electrically coupled to the second compound semiconductor layer, wherein
the second electrode is provided around the one or the plurality of light collecting structures.

13. The light emitting device according to claim 1, wherein
the first compound semiconductor layer has a mesa shape as the current narrowing structure.

14. The light emitting device according to claim 1, wherein
the first compound semiconductor layer includes a concave mirror structure on the first surface.

15. The light emitting device according to claim 1, wherein
the first compound semiconductor layer, the active layer, and the second compound semiconductor layer have a lateral surface in which a mirror structure is continuously provided.

16. The light emitting device according to claim 15, wherein
the mirror structure includes a light reflection film, a Fresnel mirror, or a parabolic mirror.

17. The light emitting device according to claim 1, wherein
the active layer includes a plurality of layers, the plurality of layers emitting light having wavelength bands different from each other.

18. An image display apparatus, comprising a plurality of light emitting devices, the plurality of light emitting devices being provided for each of a plurality of pixels arranged in an array, wherein
each of the plurality of light emitting devices includes:
a first compound semiconductor layer having a first surface and a second surface, the first surface and the second surface being opposed to each other,
an active layer facing the second surface of the first compound semiconductor layer,
a second compound semiconductor layer having a third surface and a fourth surface, the second compound semiconductor layer including one or a plurality of light collecting structures on the fourth surface, the third surface facing the active layer, and the fourth surface being opposed to the third surface and serving as a light exit surface, and
a current narrowing structure provided in the first compound semiconductor layer or the second compound semiconductor layer.

19. The image display apparatus according to claim 18, wherein
the plurality of pixels has a pitch of 20 µm or lower.

20. The image display apparatus according to claim 18, wherein
the plurality of light collecting structures has a pitch equal to or lower than the pitch of the plurality of pixels.
